# EUROPEAN PATENT SPECIFICATION

(11) **EP 4 350 754 B1**
(45) Date of publication and mention of the grant of the patent: **29.10.2025**
(21) Application number: 23201269.0
(22) Date of filing: 02.10.2023
(51) Int. Cl.: H01L 23/04, H01L 23/10, H01L 23/66, H01L 23/36, H05K 1/02

(54) **POWER AMPLIFIER PACKAGES CONTAINING ELECTRICALLY-ROUTED LIDS AND METHODS FOR THE FABRICATION THEREOF**
LEISTUNGSVERSTÄRKERGEHÄUSE MIT ELEKTRISCH GEWUNDENEN DECKELN UND VERFAHREN ZUR HERSTELLUNG DAVON
BOÎTIERS D'AMPLIFICATEUR DE PUISSANCE CONTENANT DES COUVERCLES À ROUTAGE ÉLECTRIQUE ET PROCÉDÉS DE FABRICATION DE CEUX-CI

(30) Priority: 05.10.2022 US 202217938132
(43) Date of publication of application: 10.04.2024
(73) Proprietor: NXP USA, Inc., Austin TX 78735 (US)
(72) Inventor: MAALOUF, Elie A., 5656AG Eindhoven (NL); PABST, Eduard Jan, 5656AG Eindhoven (NL); PIEL, Pierre Marie Jean, 5656AG Eindhoven (NL)
(74) Representative: Hardingham, Christopher Mark

(56) References cited:
- US-A1- 2017 229 368
- US-A1- 2022 130 768
- US-B1- 11 128 268

## Description

### TECHNICAL FIELD

Embodiments of the present disclosure relate to power amplifier packages having air cavities enclosed by electrically-routed lids and to methods for fabricating such power amplifier packages.

### BACKGROUND

A power amplifier (PA) module or package contains at least one semiconductor die bearing a transistor integrated circuit, which is utilized for radio frequency (RF) signal or power amplification purposes. In the case of a Doherty power amplifier package, for example, at least one carrier RF power die and at least one peaking RF power die are contained within the body of the PA package. The PA package may be mounted to a system-level substrate, such as a printed circuit board, supporting other discrete microelectronic components included in a larger PA circuit. In certain cases, the PA package may include a cover piece or lid enclosing an air cavity; the term "air cavity" referring to a sealed, gas-containing cavity by industry convention. In other instances, a PA package may be fabricated to lack such an air cavity and, instead, to contain an essentially void-free encapsulant body in which the RF power die or dies, as well as any other microelectronic components, are embedded. PA packages of this latter type are commonly referred to as "encapsulated," "overmolded," or "plastic" packages. Relative to fully encapsulated packages, PA packages having air cavity constructions typically provide superior electrical performance with certain tradeoffs including more costly and complex manufacture.
US11128268 describes power amplifier packages containing peripherally encapsulated dies, as well as methods for fabricating such power amplifier packages. US 11 128 268 B1 does not disclose sidewall-embedded vias contained in the peripheral lid sidewalls and a topside input/output (I/O) interface on the packaged topside surface and electrically interconnected with the RF circuitry through the sidewall-embedded vias of the electrically-routed lid.
US2022/0130768 describes leadless power amplifier packages and methods for fabricating leadless power amplifier packages having topside termination. US 2022/130768 A1 does not disclose an air cavity and an electrically-routed lid bonded to the package substrate to sealingly enclose the air cavity, and the disclosed vias are not sidewall-embedded vias.
US2017/0229368 describes air cavity composite packages with top side colling and low inductance leads. US 2017/229368 A1 does not disclose sidewall-embedded vias contained in the peripheral lid sidewalls and a topside input/output (I/O) interface on the packaged topside surface and electrically interconnected with the RF circuitry through the sidewall-embedded vias of the electrically-routed lid.
The invention is set out in the appended set of claims.

### BRIEF DESCRIPTION OF THE DRAWINGS

At least one example of the present invention will hereinafter be described in conjunction with the following figures, wherein like numerals denote like elements, and:
FIGS. 1 and 2 are topside and bottomside isometric views, respectively, of an example power amplifier (PA) package containing an air cavity enclosed by an electrically-routed lid, as illustrated in accordance with an example embodiment of the present disclosure;
FIG. 3 is an underside isometric view of the electrically-routed lid contained in the example PA package of FIGS. 1 and 2, as shown in partial cross-section and including a lower graphic depicting sidewall-embedded via regions of the lid in greater detail;
FIG. 4 a simplified top-down or planform view of the PA package shown in FIGS. 1-3, as shown in cross-section along a section plane extending through the electrically-routed lid and parallel to the X-Y plane of the coordinate legend identified in FIGS. 1-4;
FIG. 5 a side view of the PA package shown in FIGS. 1-4, as shown in cross-section along a section plane extending through the package body and parallel to the X-Z plane of the accompanying coordinate legend;
FIG. 6 is a side view of the PA package shown in FIGS. 1-5 illustrating one manner in which the PA package may be installed within a larger electronic system or assembly in an inverted or top-down orientation;
FIG. 7 illustrates an example method for fabricating a number of PA packages or modules in parallel, such as multiple instances of the PA package shown in FIGS. 1-6, utilizing a presingulated array of electrically-routed lids bonded to a presingulated array of package substrates; and
FIG. 8 is a top-down or planform view of the example presingulated lid array shown in FIG. 7, with a lower graphic showing a presingulated electrically-routed lid in greater detail. Figs. 1 - 8 fall under the scope of the present invention.

For simplicity and clarity of illustration, descriptions and details of well-known features and techniques may be omitted to avoid unnecessarily obscuring the example and non-limiting embodiments of the invention described in the subsequent Detailed Description. It should further be understood that features or elements appearing in the accompanying figures are not necessarily drawn to scale unless otherwise stated. For example, the dimensions of certain elements or regions in the figures may be exaggerated relative to other elements or regions to improve understanding of embodiments of the invention.

### DETAILED DESCRIPTION

Embodiments of the present disclosure are shown in the accompanying figures of the drawings described briefly above. Various modifications to the example embodiments may be contemplated by one of skill in the art.

The term "exemplary," as appearing throughout this document, is synonymous with the term "example" and is utilized repeatedly below to emphasize that the following description provides only multiple non-limiting examples of the invention.

The term "air cavity package," as appearing herein, refers to a microelectronic package or module including a sealed cavity filled with a gas, regardless of the internal pressure within the cavity. The "air cavity" of the air cavity package will often be enclosed in an open air environment and, thus, contain air at approximately 1 atmosphere (atm) pressure with slight variations depending upon elevation and processing temperatures during package manufacture. In other implementations, the "air cavity" of the air cavity package may be enclosed in a partially evacuated chamber or a chamber containing an inert gas, such as argon, during manufacture and, thus, may not contain pure air in all instances. The term "air cavity," then, should be understood as referring to a gas-containing cavity, which may or may not be partially evacuated and which is sealed from the ambient environment. Additionally, the seal formed between the air cavity and the ambient environment may not be hermetic, as strictly defined, but rather may be a low leakage seal having a gross leakage rate falling within acceptable parameters. For example, in certain contexts, a cavity may be considered "sealed" when little to no leakage (bubbles) is observed from the cavity's exterior when the cavity is filled with air or another gas and the air cavity package is immersed in a liquid (e.g., perfluoropolyether) at approximately 125 degrees Celsius (°). Finally, as further appearing herein, the term "package" is defined to be synonymous with and is utilized interchangeably with the term "module."

### OVERVIEW

Certain power amplifier (PA) packages, such as PA packages containing radio frequency (RF) semiconductor dies fabricated utilized power dense die technologies or operated at higher radio frequencies (e.g., frequencies approaching or exceeding approximately 2.1 gigahertz), are commonly prone to excess heat generation during package operation. In the absence of an adequate thermal solution for extracting and dissipating heat from the package interior, elevated local temperatures or "hot spots" can develop within the PA package limiting package performance. Thermal solutions traditionally implemented by manufacturers often rely upon increasing the metal content within a die supporting region of the package substrate; e.g., by forming bar vias within the package substrate or by installing a prefabricated metal body, such as a copper (Cu) coin, within a substrate cavity under the RF die or dies housed within the package. Such an embedded thermal dissipation structure (e.g., a metal slug or via farm) may form or help form a low thermal resistance heat transfer path extending from the RF circuitry (e.g., RF power dies) within the PA package to a thermal interface availed on the package exterior, such as an exposed surface of an embedded metal coin or a backmetal layer formed on the package bottomside. PA packages of this type may be imparted with a leaded formfactor or a flat no lead formfactor, such as a dual flat no lead (DFN) or a quad flat no lead (QFN) formfactor. When imparted with a flat no lead formfactor, the PA packages may include contacts, such as land grid array (LGA) pads, on the package bottomside surface forming an input/output (I/O) interface. The LGA pads are commonly arranged in multiple rows, which extend along an outer peripheral region of the package bottomside surface and flank the package's thermal interface. When the PA package is mechanically and electrically attached to a system level substrate (e.g., by soldering to a motherboard or other system-level printed circuit board (PCB)), conductive heat flow and electrical signals are both routed through the package bottomside during PA package operation.

More recently, dual-sided PA package architectures have been developed in which the thermal interface and the package I/O interface are provided on opposing principal surfaces of the package. Specifically, in such package architectures, the package I/O interface may be provided along the package topside surface, while the package thermal interface is availed along the package bottomside surface. PA packages of this type are referred to herein as "high thermal performance" or "HTP" packages. Such PA packages, when imparted with HTP architectures or designs, benefit from enhanced heat dissipation to limit peak operational temperatures occurring within the PA package, particularly when operated at higher power levels and frequencies or containing RF power dies having relatively high power densities. This, in turn, may improve the package electrical performance and operational lifespan relative to more conventional PA packages lacking HTP designs. These benefits notwithstanding, presently-suggested approaches for fabricating or constructing HTP packages present certain challenges. For example, in one approach for fabricating HTP PA packages, one or more interposer pieces are initially bonded to a PCB serving as the package substrate. The interposer pieces may be PCB blocks or electrically-routed ceramic pieces, which are soldered to the populated side of the package substrate and extend upwardly therefrom. In certain instances, a single ring-shaped interposer piece may be bonded to the populated side of the package substrate; while, in other cases, multiple block-shaped interposer pieces may be spaced around the populate side of the PCB and so bonded. Following component population (e.g., RF die attach) and wirebonding, the interposer piece or pieces, the RF power dies, and any other packaged components contained in the circuit layout may be overmolded with a dielectric mold compound (e.g., utilizing a film assisted molding technique) to yield an encapsulant body in which the RF circuity and interposer pieces are embedded. The upper surface of the encapsulant body may define the package topside surface along which the package topside I/O array is located, as well as provide a flat surface facilitating pick-and-place operations during package manufacture. A thermal interface may be provided on the opposing package backside, with a primary heat extraction path extending from the thermal interface, through one or more thermal dissipation structures (e.g., embedded Cu coins), and to the RF power die or dies within the PA package to complete the HTP package architecture.

While enhancing thermal performance attributes, molded HTP PA packages of the type just described remain limited in certain respects. Many of these limitations pertain to the presence of the overmold or encapsulant material itself, which inherently possesses a higher dielectric constant than does a gas-filled cavity; e.g., many thermoplastics or mold compounds utilized for encapsulation purposes have a dielectric constant ranging from about 3.5 to about 3.8 relative to a dielectric constant of essentially 1 in the case of air. Thus, the presence of the encapsulant material may also increase cross coupling between wirebond arrays, matching elements, and the I/O terminals of the package. In contrast to the gas-filled space within a PA package having a sealed air cavity, the dielectric encapsulant within an overmolded PA package can shift or otherwise alter the electrical performance parameters (e.g., gain and efficiency) of the PA package. While some fraction of the resulting performance detriment may be recovered through iterative post-mold tuning, some of this performance loss remains non-recoverable. Moreover, iterative post-mold tuning adds further design cycles, with post-mold tuning typically entailing the time-intensive and highly manual process of excavating overmolded matching components to allow such components to be modified or swapped with other components to allow additional testing and design iterations. As a further issue, the overmolding process employed to form the encapsulant body may be prone to mold flash, which may extend onto the contacts of the PA package and interfere with bonding of the PA package to a system-level substrate. Still other issues associated with overmolded or plastic HTP PA package designs can arise from the incorporation of the interposer piece or pieces into the molded package body. Geometric irregularities or coplanarity issues can occur across I/O plane of the PA package due to varying interposer heights and solder joint thicknesses, undesired solder extrusion can occur from the interposer joints, and moisture can become trapped beneath (or potentially ingress into) small voids between the interposer pieces and the package substrate, depending upon manufacturing tolerances and other factors. Any or all of these issues may negatively impact the structural integrity or performance of the PA package to vary degrees.

Considering the above, there exists an ongoing industrial demand for PA packages capable of overcoming most, if not all of the aforementioned limitations, while remaining readily adaptable to the incorporation of HTP architectures and amenable to cost effective manufacture. HTP PA packages having such attributes are described herein, as are methods for fabricating such PA packages in bulk or at scale to achieve increased process efficiencies and manufacturing cost reductions. As described in greater detail below, embodiments of the presently-disclosed PA packages contain air cavities, which are sealingly enclosed utilizing specialized, electrically-routed lids; the term "electrically-routed lid," as appearing herein, referring to a cover piece or lid containing vias extending within one or more of the peripheral lid sidewalls to provide electrical connections between an I/O interface (e.g., a topside I/O interface) of the PA package and RF circuity contained within the package interior. Such vias are described as "sidewall-embedded vias" and may be wholly or entirely embedded within a given lid sidewall or may instead be partially embedded in a lid sidewall (e.g., such that the via can be seen from the package interior or exterior). The sidewall-embedded vias provide electrical connection between terminals (e.g., electrically-conductive pads) in the topside I/O interface of the PA package and contacts spaced along an underside edge or surface of the electrically-routed lid. The sidewall-embedded vias can include or assume the form of any structure extending within the lid sidewalls in an essentially vertical or package height direction and providing electrically-conductive paths from the substrate-facing lid contacts to the topside I/O terminals provided on the lid topside. Such vias may be produced utilizing embedded metal structures, such as metallic columns or rods provided as discrete pieces or initially provided as a physically-interconnected array or structure and subsequently singulated during the manufacturing process. In other instances, the sidewall-embedded vias may be formed as through holes or vertical notches backfilled with an electrically-conductive material, such as an electrically-conductive epoxy or a sintered metallic material. As a still further example, in embodiments, the sidewall-embedded vias may be formed as plated through holes, which are produced by drilling holes through the dielectric cover body, plated, backfilled with a conductive or non-conductive material, and then capped (e.g., through formation of topside bondpads serving as terminals in the topside I/O interface).

Continuing the foregoing paragraph, the contacts present on the underside edge or surface of the electrically-routed lid are referred to herein as "substrate-facing lid contacts" and may assume the form of bondpads spaced in rows vertically overlapping or aligning with the terminals of the topside I/O interface; the term "vertical" referring to an axis orthogonal to the package topside surface and synonymous with the term "package height direction" herein. A corresponding set of contacts (herein, "lid-facing contacts") may be provided on the populated side of the package substrate and electrically interconnected to the substrate-facing lid contacts. RF circuitry, which may include one or more power RF dies and any practical number of other microelectronic components (e.g., surface mount device (SMD) capacitors, resistors, or inductors), is further attached to the populated side (lid-facing side) of the package substrate and electrically interconnected with the topside I/O interface through lid-facing contacts, through the substrate-facing lid contacts, and through the sidewall-embedded vias. A robust electrical routing scheme is consequently provided for interconnecting the RF circuitry with the topside I/O interface without reliance upon the inclusion of overmolded interposer pieces within the package body. Additionally, in at least some embodiments, a unique bond layer system may be utilized to attach the electrically-routed lid to the package substrate, while providing a high integrity, 360° seal bounding the air cavity at lid-substrate interface. In at least some realizations, such a bond layer system may be formed to contain a dielectric bond layer and electrically-conductive bodies, which are distributed in the dielectric bond layer at locations between corresponding pairs of lid-facing and substrate-facing lid contacts. Furthermore, in certain implementations, the dielectric bond layer may be applied as a B-stage epoxy initially dispensed in a wet state (e.g., as a paste), which undergoes (e.g., second stage) curing during the lid attach process to create the desired seal about the lid-substrate juncture and sealingly enclose the package air cavity.

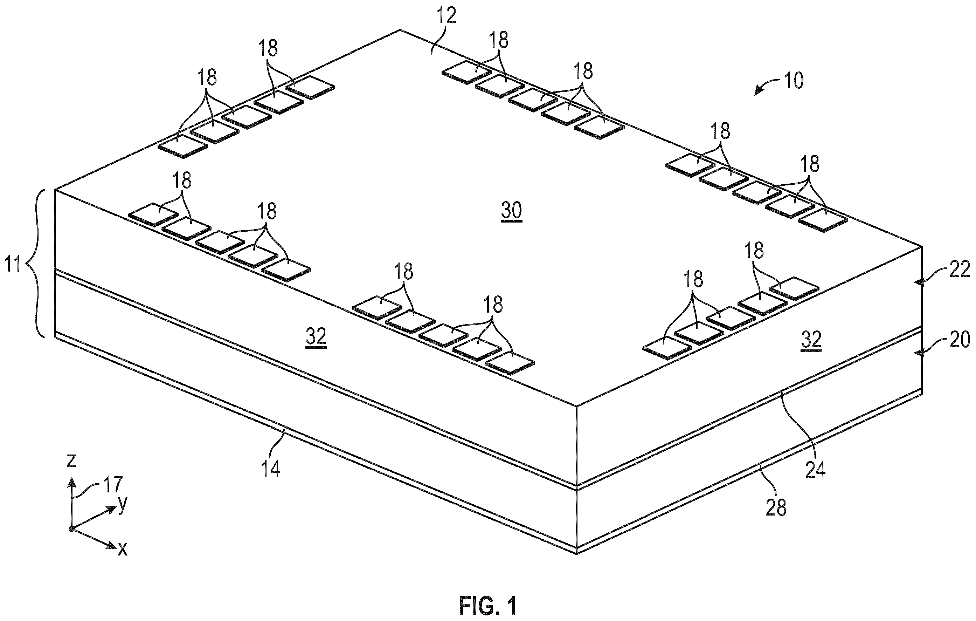

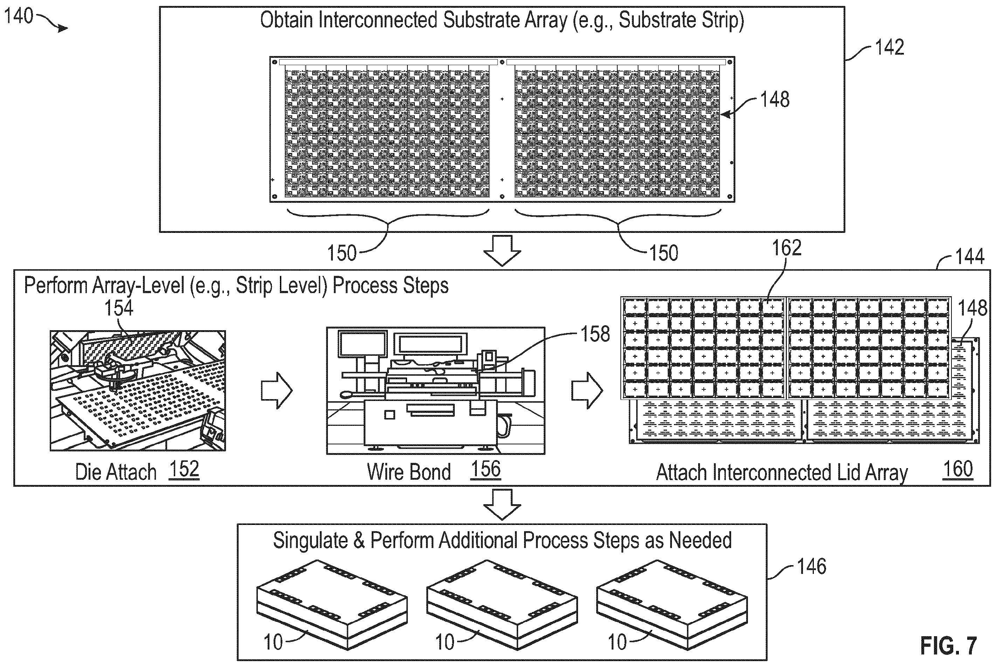

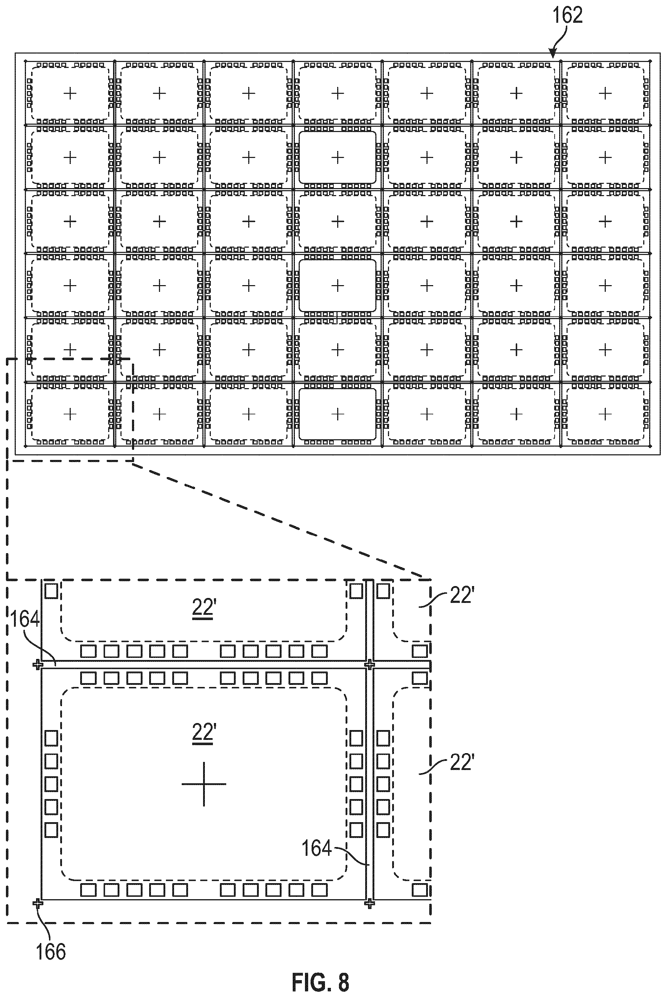

In the above-described manner, HTP PA packages can be fabricated possessing air cavity constructions to enhance the electrical performance characteristics of the PA packages, while optimal thermal performance is achieved by virtue of the package's dual-sided HTP architecutre. Additionally, relative to comparable overmolded or plastic PA packages containing encapsulated components and interposer pieces, the presently-disclosed PA packages are less susceptible to coplanarity issues along the package mount plane and avoid challenges involving interposer piece attachment and overmolding. Such benefits may be optimized when an epoxy attach process is utilized to bond the electrically-routed lid to the package substrate; e.g., noting that cured epoxy materials are generally impervious to, or at least less prone to, reflow issues observed with some solder materials. As a still further advantage, embodiments of the presently-disclosed HTP PA packages are amenable to fabrication at scale or in larger numbers by processing a presingulated package substrate array to which a presingulated lid array (containing a plurality of physically-connected, electrically-routed lids) is attached. This may be accomplished utilizing, for example, an epoxy attach process of the type further discussed below; e.g., by screen printing or otherwise dispensing a wet state epoxy at the appropriate locations between the substrate and lid arrays to simultaneously enclose multiple air cavities during lid attach and epoxy curing stages. Example fabrication processes carried-out on a large (panel- or strip-level) scale to concurrently produce multiple (e.g., several dozen) PA packages in parallel are further discussed herein in connection with FIGS. 7 and 8. First, however, examples of such PA packages containing air cavities and electrically-routed lids are set-forth below in connection with FIGS. 1-6.

### EXAMPLE POWER AMPLIFIER PACKAGE WITH ELECTRICALLY-ROUTED LID

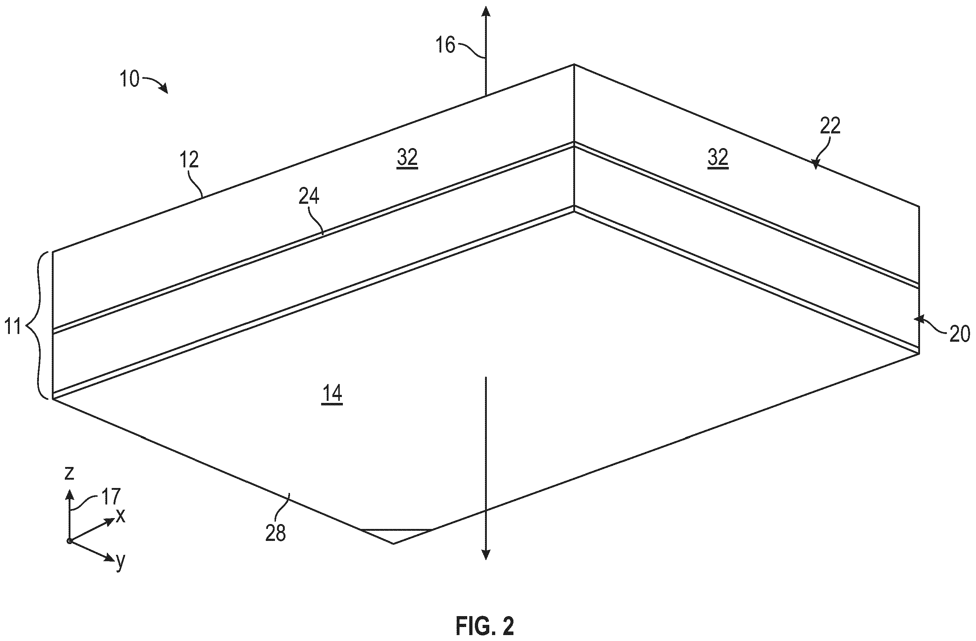

FIGS. 1 and 2 are top and bottom isometric views of a power amplifier (PA) package **10,** respectively, as illustrated in accordance with an example embodiment of the present disclosure. PA package **10** includes a package body **11** having an upper principal surface (herein, "package topside surface **12**") and a lower principal surface (herein, "package bottomside surface **14**")**.** As appearing herein, the term "package topside surface" refers to an outer principal surface of a PA package opposite the package substrate (e.g., package substrate **20** described below), while the term "package bottomside surface" refers to the opposing principal surface of the package in question, as taken the package centerline extending substantially orthogonal to the topside and bottomside surfaces. In the illustrated example, specifically, package topside surface **12** and package bottomside surface **14** are opposed along a package centerline **16** (FIG. 2), which is orthogonal to surfaces **12, 14** and extends parallel to the Z-axis of coordinate legend **17** (shown in the bottom right of FIGS. 1 and 2). The terms "vertical" or "package height direction" are also utilized herein to refer to a direction or axis parallel to package centerline **16.** A number of terminals or electrical contacts are provided on package topside surface **12** and collectively form a topside I/O interface **18.** In this particular example, the terminals of topside I/O interface **18** assume the form of LGA pads imparting PA package **10** with a flat no lead form factor. As shown most clearly in FIG. 1, the LGA pads may be arranged in multiple groups or rows, which are spaced along the outer peripheral region of package topside surface **12** to define the mount plane or I/O plane of PA package **10.** In alternative implementations, PA package **10** can be fabricated to have other formfactors with topside I/O interface **18** potentially defined by another contact array, such as a ball grid array, formed on package topside surface **12.**

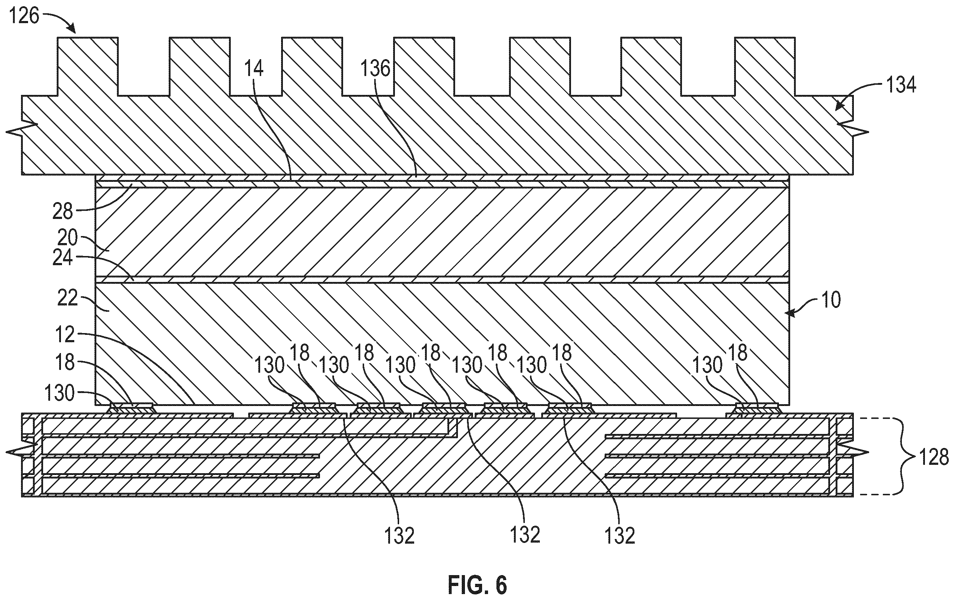

PA package **10** is imparted with a dual-sided HTP architecture in the illustrated embodiment. In this regard, and as shown most clearly in FIG. 2, PA package **10** is fabricated to have a thermal (heat extraction) interface availed or exposed along package bottomside surface **14.** The bottomside thermal interface may assume the form of, for example, one or more metallic surfaces accessible from, and substantially coplanar with, package bottomside surface **14.** Package bottomside surface **14** of PA package **10** is defined by a plated metal layer or multi-layer system **28** (hereafter, "backmetal layer **28**"), which serves as the thermal interface of PA package **10** and which extends along the lower surface of package substrate **20.** When PA package **10** is installed within a larger microelectronic system, the thermal interface of PA package **10** may further be placed in thermal communication with a heatsink (e.g., a metal chassis or fin array) contained in a PA system to promote conductive heat extraction from the interior of PA package **10** and dissipation by convective transfer to the surrounding ambient environment, as described more fully below in connection with FIG. 6. Package body **21** of PA package **10** is defined, at least in principal part, by a package substrate **20** and an electrically-routed cover piece or lid **22.** Package substrate **20** assumes the form of a multi-layer PCB or printed wiring board in the illustrated example but may assume other forms, including that of a leadframe-based substrate or a ceramic substrate, in further implementations providing the desired electrical interconnections can be formed between the packaged RF circuitry (e.g., the below-described RF power dies) and the sidewall-embedded vias extending within electrically-routed lid **22.**

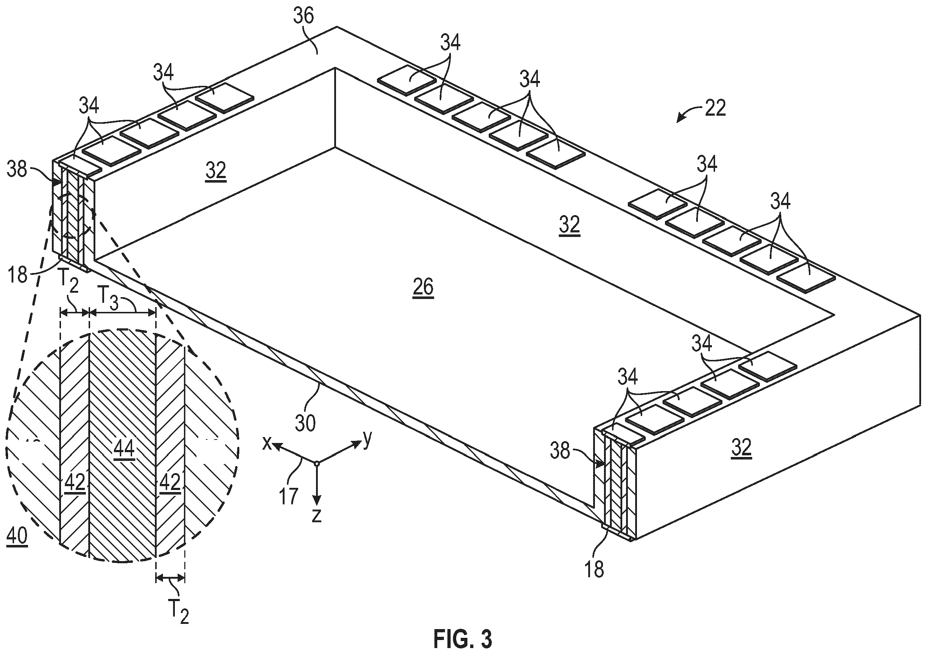

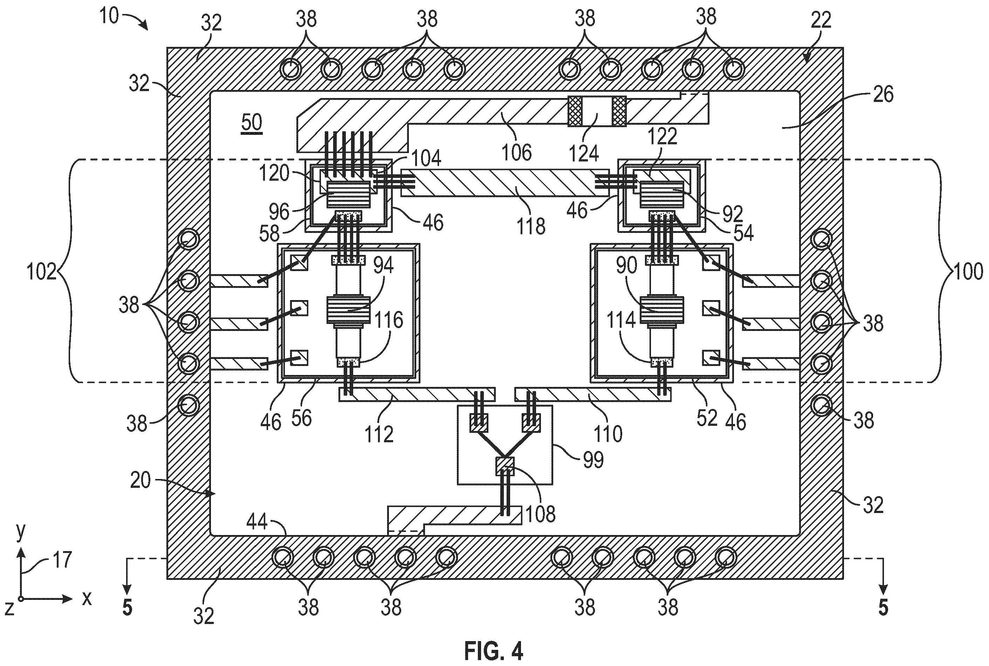

Referring now to FIGS. 3 and 4 in combination with FIGS. 1 and 2, electrically-routed lid **22** is bonded to package substrate **20** through a bond layer system **24** to sealingly enclose an air cavity **26** within the interior of PA package **10.** As shown most clearly in FIG. 3, which depicts the underside of electrically-routed lid **22** (shown in an inverted or "flipped" orientation relative to the orientation shown in FIGS. 1 and 2), electrically-routed lid **22** has an open, box-like geometry and includes an upper lid wall **30** and four peripheral lid sidewalls **32.** Peripheral lid sidewalls **32** are joined to and extending from upper lid wall **30** toward package substrate **20.** Substrate-facing lid contacts **34** are distributed along a lower edge **36** of peripheral lid sidewalls **32,** the lower edge having a generally rectangular ring-like shape as viewed form the underside of lid **22.** Substrate-facing lid contacts **34** may be bond pads formed on lower edge **36** and arranged in several rows or groupings, as shown. In embodiments, each substrate-facing lid contact **34** may align or overlap with a corresponding terminal (e.g., LGA pad) included in topside I/O interface **18,** as taken along an axis transecting the contact and terminal pair and extending in the package height direction (again, parallel to the Z-axis of coordinate legend **17**)**.** Further, as previously indicated, the topside I/O interface or array **18** of PA package **10** may be defined by form of electrically-conductive pads formed on a surface of the upper lid wall facing away from package substrate **20** and in electrical contact with vertically-extending electrical conductors or vias running within lid **22,** as discussed below.

As indicated by the term "electrically-routed," lid **22** is fabricated to contain certain internal electrically-conductive features, which help provide electrical interconnection between RF circuitry contained in air cavity **26** and topside I/O interface **18** of PA package **10.** Specifically, and as shown most clearly in Fig. 3, electrically-routed lid **22** is produce to contain a number of sidewall-embedded conductors or vias **38,** which are embedded in peripheral lid sidewalls **32** and spaced in several groupings or rows. In at least some instances, sidewall-embedded vias **38** may be wholly or entirely embedded within peripheral lid sidewalls **32** such that each via **38** is not visible or hidden from the package exterior or interior. Stated differently, in such embodiments, sidewall-embedded vias **38** may not breach either the inner our outer peripherals of lid sidewalls **32.** In other instances, sidewall-embedded vias **38** may be exposed from the package exterior or interior and breach the package sidewalls to some degree. In this latter case, sidewall-embedded vias **38** may occupy vertically-extending trenches or slots formed in peripheral lid sidewalls **32.** Regardless, each sidewall-embedded via **38** may assume the form of any electrical conductor or electrically-conductive structure contained within a peripheral lid sidewall and providing electrical connection from substrate-facing lid contacts **34** to corresponding terminals in topside I/O array **18.** It is also possible to fabricate lid **22** to include internal walls or structures, which may or may not contain vias similar to sidewall-embedded vias **38,** alternative realizations.

The body or bulk of electrically-routed lid **22** may be composed of a dielectric resin material of the type utilized in PCB fabrication, a ceramic, or a thermoplastic material, such as a liquid crystal polymer (LCP) material, to list but a few examples. In certain embodiments, the dielectric body of electrically-routed lid **22** may be formed around pre-existing or premanufactured metal pieces (or other electrically-conductive structures) to produce sidewall-embedded vias **38** during lid fabrication. For example, in such cases, the electrically-conductive pieces serving as vias **38** may assume the form of structurally-separate or discrete electrically-conductive pieces (e.g., metal blocks or rods), which are arranged in a desired spatial layout or positioning utilizing a specialized fixture. Overmolding may then be performed, and the fixture removed following embedment of the metal (or other electrically-conductive pieces) within the lid. In other instances, such electrically-conductive pieces may be initially interconnected or physically tied together in some manner, overmolded, and then physically separated and electrically isolated post overmolding; e.g., by sawing during the singulation process. In still other manufacturing approaches, the dielectric lid body may be initially produced (e.g., via molding of a thermoplastic or by machining of a dielectric blank) to include unfilled through holes or tunnels in which sidewall-embedded vias **38** are ultimately formed. In this latter instance, the through holes may be formed as part of the molding process (when applicable); or, instead, produced subsequent to molding utilizing a suitable material removal process, such as mechanical drilling. Following this, discrete metallic pieces can be inserted or press-fit into the through holes and bonded to any existing contact pads, as appropriate. Alternatively, an electrically-conductive material can be deposited or dispensed into the through holes in sufficient quantity to provide the desired electrical connection between corresponding sets of LGA pads **18** and substrate-facing lid contacts 34, which may be subsequently produced depending upon the manufacturing approach employed. In the latter regard, an electrically-conductive wet state material can be dispensed or backfilled into the through holes and cured. Materials suitable for this purpose include electrically-conductive epoxies and metal particle-containing pastes, which may be sintered to form metallic (e.g., sintered Cu or silver (Ag)) bodies within the through holes to provide the desired electrical connections.

As a still further possibility, sidewall-embedded vias **38** can be formed as plated through holes and are depicted as such in FIGS. 1-4. In this regard, and referencing detail bubble **40** shown in a lower left corner of FIG. 3, sidewalls-embedded vias **38** are produced to each include a tubular plated layer **42** and an innermost fill material **44** (herein, "via core fill **44**")**.** Via core fill **44** is surrounded by tubular plated layer **42** and may be produced from a conductive or non-conductive material, which is chemically compatible with plated layer **42;** e.g., via core fill **44** will often be composed of a dielectric epoxy material dispensed into the via space following build-up of tubular plated layer **42.** Tubular plated layer **42** provides an electrically-conductive path extending from substrate-facing lid contacts **34** to topside terminals **18.** Tubular plated layer **42** may be composed of any electrically-conductive material amenable to plating and, in embodiments, may be predominately composed of Cu or another metal, by weight. In one approach, sidewall-embedded vias 38 may be created in electrically-routed lid **22** in the following manner. First, unfilled through holes or tunnels are formed in the dielectric body of electrically-routed lid **22** utilizing a material removal process, such as mechanical drilling. Following this, a plating process is carried-out (e.g., including depositing a seed layer or activating surfaces to be plated, as the case may be) to form tubular plated layers **42.** Next, a dielectric backfill material is dispensed into the remaining void space within each via surrounded by the newly-formed tubular plated layers **42** utilizing, for example, a fine needle dispense or screen printing technique. Lastly, the plated through holes (vias **38**) are capped with an electrically-conductive pad serving as one LGA pads **18** or substrate-facing lid contacts **34,** depending upon the side of lid **22** positioned in an upwardly-facing orientation during the manufacturing process (with the pads **18** or contacts **34** in a downwardly-facing orientation potentially serving as via catch pads). Further, in embodiments, in which peripheral lid sidewalls **32** each have a thickness of T1 (as taken along axes perpendicular to the package height direction), plated tubular layer has a radial thickness of T2, via core fill **44** has a diameter of T3, and vias **38** each have a total diameter of 2(T2)+T3, T1 may range from about 800 to about 1000 microns (µm), T2 may range from about 20 to about 40 µm, and T3 may range from about 100 to about 200 µm. In other embodiments, T1, T2, and T3 may be greater than or less than the aforementioned range.

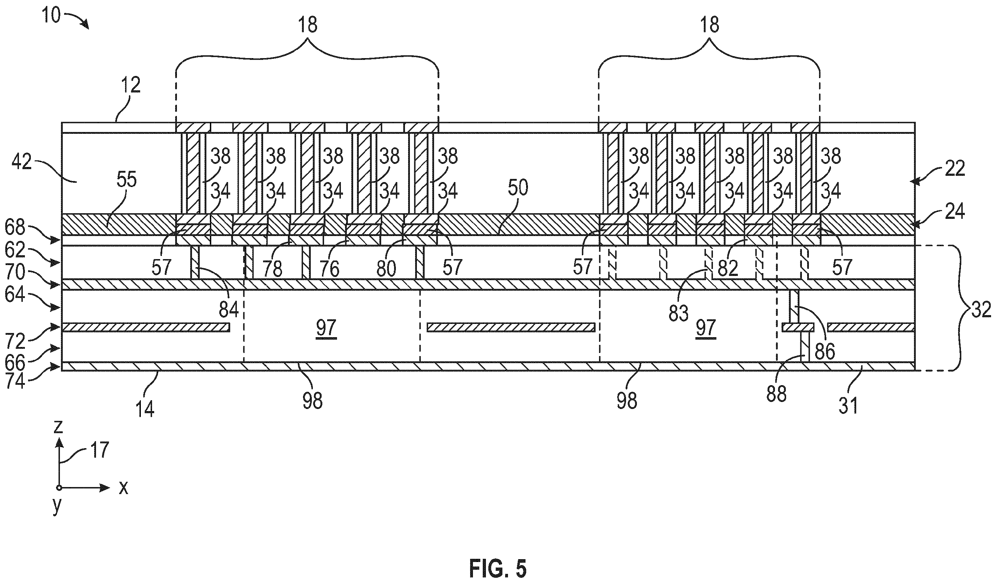

Discussing now FIGS. 4 and 5 in combination with FIGS. 1-3, an example PA circuit layout suitably contained in or housed within PA package **10** will be described. The following description is provided by way of example to establish a non-limiting context in which embodiments of PA package **10** may be better understood. It is emphasized that PA package **10** can contain various different components and have a nearly infinite range of circuit layouts, providing that package **10** contains at least one RF power die utilized for signal or power amplification purposes and regardless of whether the PA circuit at issue has a Doherty design or another (e.g., push-pull) amplifier design. Referring initially to FIG. 4, air cavity **26** and a component-supportive frontside surface **50** (also referred to as "populated side **50"**) of package substrate **20** can be seen in this view. A number of microelectronic components, including power transistor or amplifier dies 52, 54, 56, 58, are mounted to populated side 50 of substrate 20. In the illustrated example, package substrate 20 assumes the form of a multilayer PCB; however, in other embodiments, package substrate 20 can assume other forms, whether containing or lacking electrical-routing features (e.g., Cu traces), including that of a leadframe-based substrate, a ceramic substrate, or a single layer PCB. A plurality of components (including power transistor dies 52, 54, 56, 58) and electrically-routed lid 22 are mechanically attached and electrically coupled to populated surface 50 of package substrate 20. Lid-facing contacts 76, 78, 80, 82 (FIG. 5) are provided on populated surface 50 of package substrate 20 and electrically coupled to corresponding ones of substrate-facing lid contacts 34 through bond layer system 24, as further described below.

Bond layer system **24** may include any number of bond layers having varying compositions suitable for providing a high integrity, 360° seal around (bounding a perimeter of) air cavity **26** at the lid-substrate interface, while also providing robust electrical connection between corresponding pairs of substrate-facing lid contacts **34** on the lower edge of lid **22** and lid-facing contacts **76, 78, 80, 82** (FIG. 5) provided on the outer peripheral bands of populated side **50** of substrate **20.** In the illustrated example, bond layer system **24** includes a primary dielectric bond layer **55** in which more discrete, electrically-conductive bond layer portions **57** are distributed. Electrically-conductive bond layer portions **57** are formed in dielectric bond layer 55 at locations between corresponding pairs of lid-facing and substrate-facing lid contacts **34, 76, 78, 80, 84** to provide the appropriate electrical connections through bond layer system **24.** In certain implementations, dielectric bond layer **55** may be applied as a B-stage epoxy, which undergoes (e.g., second stage) curing during the lid attach process, as further discussed below in connection with FIGS. 7 and 8. Such an epoxy may be dispensed in a wet state (e.g., utilizing a screen printing or fine needle dispense process) prior to seating or positioning electrically-routed lid **22** onto package substrate **20.** Alternatively, such an epoxy can be provided as a dry film (e.g., as formed upon initial curing), with the dry film positioned or captured between electrically-routed lid **22** and package substrate **20** and subjected to B-stage curing during the lid attach process. Comparatively, electrically-conductive bond layer portions **57** may be discretely deposited bodies of an electrically-conductive material (e.g., a second, non-conductive epoxy or a sintered metallic material), which are surrounded by and contact dielectric bond layer **55** to maintain a high integrity (e.g., essentially zero or acceptably low leakage) seal at the lid-substrate interface.

As depicted most clearly in FIG. 5, package substrate **20** includes several dielectric layers **62, 64, 66** composed of, for example, FR-4, ceramic, or other PCB dielectric materials. Dielectric layers **62** are disposed in an alternating or interleaved arrangement with a number of patterned metal layers **68, 70, 72, 28.** Populated surface **50** of package substrate **20** is at least partially defined by a patterned metal layer **68,** while non-populated surface **31** of package substrate **20** is defined by a patterned metal layer **28** or a continuous ground plane layer (also identified as "backmetal layer **28"** and "backside thermal interface **28"** here). While package substrate **20** is shown to include three dielectric layers **62, 64, 66** interspersed with four patterned metal layers **68, 70, 72, 28,** other embodiments of package substrate **20** may include a greater or lesser number of dielectric layers and patterned metal layers. Each of the various patterned metal layers **68, 70, 72, 28** may have a primary purpose, and also may include conductive features facilitating signal and/or voltage/ground routing between other layers. Although the description below indicates a primary purpose for each of patterned metal layers **68, 70, 72, 28,** the layers (or their functionality) may be arranged differently relative to the illustrated arrangement.

In the illustrated embodiment, uppermost metal layer **68** of package substrate **20** is patterned to define a number of electrically-conductive bondpads **76, 78, 80** (FIG. 5) for attachment of electrically conductive signal, bias, and/or ground terminals (contacts **34**) of electrically-routed lid **22** and, in turn, with the corresponding contacts in topside I/O array or interface **18.** In certain instances, patterned metal layer **68** may also include a plurality of "dummy" pads, such as one or more bondpads **82** (FIG. 5), to which "dummy" terminals may be attached. As appearing herein, the term "dummy terminal" refers to an interposer terminal that is not assigned any particular function in an amplifier IC or PA package and, therefore, is electrically decoupled from any active circuitry. In various embodiments, the dummy terminals and dummy pads **82** may be remain electrically floating (that is, left uncoupled to ground or other circuitry); or, alternatively, may be coupled to a ground layer, such as internal ground plane layer **70,** as indicated by dashed line vias **83.** The conductive features of patterned metal layer **70** may be electrically coupled to various conductive features of patterned metal layer **68** (a signal conducting layer) and to patterned metal layer **70** (e.g., a system ground layer) with conductive vias **84, 86, 88** extending through dielectric layers **62, 64, 66.** For example, conductive ground terminal pads **78, 80** may be electrically coupled through vias **84** to patterned metal layer **70.** A third patterned metal layer **72** functions to convey bias voltages to power transistors **90, 92, 94, 96** within dies **52, 54, 56, 58,** and also may function as a routing layer, as mentioned above. Finally, a fourth patterned metal layer **74** functions as a system ground layer and also as a heatsink attachment layer in embodiments.

Package substrate **20** may further contain one or more thermal dissipation (heat transfer) structures **97,** which extend between surfaces **31, 50** of package substrate **20.** When so provided, IC dies **52, 54, 56, 58** may be physically and electrically coupled to the uppermost surfaces of thermal dissipation structures **97** exposed at populated surface **50** of package substrate **20.** Bottom surfaces **98** of thermal dissipation structures **97** may be exposed at non-populated surface **31** of package substrate **20,** or bottom surfaces **98** of thermal dissipation structures **97** may be covered with bottommost metal layer **28,** as shown in FIG. 5. In either instance, thermal dissipation structures **97** provide a thermal pathway between dies **52, 54, 56, 58** and bottom surfaces **98** of thermal dissipation structures **97** and, therefore, non-populated surface **31** of package substrate **20.** In various embodiments, thermal dissipation structures **97** may include conductive metallic coins press-fit and/or otherwise attached into through-holes extending between opposing sides or surfaces of package substrate **20.** In alternative embodiments, each of thermal dissipation structures **97** may include a plurality or a set of conductive thermal vias, such as circular or bar vias, extending between principal surfaces or sides **31, 50** of package substrate **20.** As described in more detail below, exposed bottom surfaces **98** of thermal dissipation structures **97** (or the portion of patterned metal layer **28** overlying those surfaces **98**) are physically and thermally coupled to a heatsink when PA package **10** is integrated within a larger electrical system.

The terminals or contacts included in topside I/O interface **18** of PA package **10** include an RF input terminal **76** and an RF output terminal **78** (identified in FIGS. 1 and 4). The following circuit elements or components are contained within PA package **10** and electrically coupled between terminals: (i) a power splitter **99;** (ii) a two-stage, carrier amplifier section **100;** (iii) a two-stage peaking amplifier section **102;** (iv) a number of phase shift and impedance matching elements; (v) a combining node **104;** and (vi) an output-side impedance matching network **106.** Through one or more electrically-conductive structures or interconnect features (e.g., vias, traces, and/or wirebonds, as shown), RF input terminal **76** is electrically coupled to an input **108** of power splitter **99.** Similarly, through one or more interconnect features (e.g., vias, traces, and/or wirebonds), RF output terminal **78** is electrically coupled to combining node **104** via output-side impedance matching network **106.** Power splitter **99** is coupled to populated surface or populated side **50** of package substrate **20** and may include one or more discrete die and/or components. As noted above, power splitter **99** includes an input terminal **108** and two output terminals (not labeled). Input terminal **108** of power splitter **99** is electrically coupled to RF input terminal **76** through one or more conductive structures (e.g., vias, traces, and/or wirebonds, as shown). The output terminals of power splitter **99** are electrically coupled through one or more conductive structures (e.g., vias, traces, and/or wirebonds) and input circuits **110, 112** to inputs **114, 116** of carrier and peaking amplifier sections **100, 102,** respectively. Power splitter **99** is configured to divide the power of the input RF signal received through the RF input terminal into first and second RF signals, which are produced at the output terminals of power splitter **99.** In addition, power splitter **99** may include one or more phase shift elements configured to impart a 90°phase difference between the RF signals provided at the splitter output terminals.

The first output of power splitter **99** is electrically coupled to a carrier amplification path extending within PA package **10,** while the second output of power splitter **99** is electrically coupled to a peaking amplification path within PA package **10.** The RF signal produced at the second output of splitter **99** may be delayed by about 90° from the RF signal produced at the first power splitter output. Stated differently, the RF signal provided to the peaking amplification path may be delayed by about 90 degrees from the RF signal provided to the carrier amplification path. Due to this arrangement, the first RF signal generated by power splitter **99** is amplified through the carrier amplification path, while the second RF signal produced by power splitter **99** is amplified through the peaking amplification path. In the depicted embodiment, each of the carrier and peaking amplification paths extends through a two-stage power amplifier section in which a driver-stage transistor **90, 94** is implemented on a driver-stage die **52, 56,** while a final-stage transistor **92, 96** is implemented on a separate final-stage die **54, 58.** For example, each of transistors **90, 92, 94, 96** may be field effect transistors (FETs), such as laterally-diffused metal oxide semiconductor (LDMOS) FETs or high electron mobility transistors (HEMTs). The description and claims may refer to each transistor as including a control terminal and two current-conducting terminals. For example, utilizing terminology associated with FETs, a "control terminal" refers to a gate terminal of a transistor, and first and second current-conducting terminals refer to drain and source terminals (or vice versa) of a transistor. Although the below description may use terminology commonly used in conjunction with FET devices, the various embodiments are not limited to implementations the utilize FET devices, and instead are meant to apply also to implementations that utilize bipolar junction transistors (BJT) devices or other suitable types of transistors.

In the illustrated example, carrier amplifier section **100** of PA package **10** includes a silicon driver-stage die **52** and a gallium nitride (GaN) final-stage die **54;** while peaking amplifier section **102** likewise includes a silicon driver-stage die **56** and a GaN final-stage die **58.** In other embodiments, each of carrier and peaking amplifier sections **100, 102** may include a two-stage power amplifier implemented on a single die, or each of carrier and peaking amplifier sections **100, 102** may include a single-stage power amplifier implemented on a single die. In still other implementations, each of carrier and peaking amplifier section **100, 102** may include a two-stage power amplifier implemented on separate driver and final-stage dies, but the driver and final-stage dies may be formed utilizing the same semiconductor technology (e.g., both the driver and final-stage dies are silicon dies or GaN dies), or the driver and/or final-stage dies may be formed utilizing different semiconductor technologies than those described above (e.g., the driver and/or final-stage dies may be formed from silicon germanium (SiGe) and/or gallium arsenide (GaAs) die).

With continued reference to FIGS. 1-5, and with attention specifically directed towards FIG. 4, carrier amplification section **100** includes above-mentioned driver-stage die **52,** final-stage die **54,** and a phase shift and impedance inversion element **118.** Driver-stage die **52** and final-stage die **54** of carrier amplifier section **100** may be electrically coupled in a cascade arrangement between an input terminal **114** of driver-stage die **52** (corresponding to a carrier amplifier input) and an output terminal **122** of final-stage die **54** (corresponding to a carrier amplifier output). In embodiments, the integrated circuitry of driver-stage die **52** may include a series-coupled arrangement of input terminal **114,** a silicon power transistor **90,** and the following non-labeled features: an input impedance matching circuit, an integrated portion of an interstage impedance matching circuit, and an output terminal. The gate of transistor **90** is electrically coupled through the input impedance matching circuitto input terminal **114,** while the drain of transistor **90** is electrically coupled through the output-side impedance matching circuit to the output terminal of die **52.** The source of transistor **90** is electrically coupled to a patterned metal layer (or source terminal) on a bottom surface of die **52;** and the bottom patterned metal layer is physically, electrically, and thermally coupled to the exposed top surface of a thermal dissipation structure **97.** The output terminal of driver-stage die **52** is electrically coupled to the input terminal of final-stage die **54** through a wirebond array or another type of electrical connection. Final-stage die **54** also includes a plurality of integrated circuits; e.g., a series-coupled arrangement of an input terminal (not numbered), a GaN power transistor **92,** and an output terminal **122.** The gate of transistor **92** may be electrically coupled to the input terminal of die **54,** and the drain of transistor **92** is electrically coupled to output terminal **122** of die **54.** The source of transistor **92** is electrically coupled to a patterned metal layer on a bottom surface of die **54;** and the bottom patterned metal layer is physically, electrically, and thermally coupled to the exposed top surface of a thermal dissipation structure **97.**

The peaking amplification path includes the above-mentioned driver-stage die **56** and final-stage die **58.** Driver-stage die **56** and final-stage die **58** of the peaking amplification path are electrically coupled together in a cascade arrangement between an input terminal **116** of driver-stage die **56** (corresponding to a peaking amplifier input) and an output terminal **120** of final-stage die **58** (corresponding to a peaking amplifier output). Driver-stage die **56** may include a plurality of ICs. In an embodiment, the integrated circuitry of die **56** includes a series-coupled arrangement of input terminal **116,** an input impedance matching circuit (not numbered), a silicon power transistor **94,** an integrated portion of an interstage impedance matching circuit (not numbered), and an output terminal not numbered, in an embodiment. In particular, the gate of transistor **94** is electrically coupled through the input impedance matching circuit to input terminal **116,** and the drain of transistor **94** is electrically coupled through the output-side impedance matching circuit to the output terminal of die **56.** The source of transistor **94** is electrically coupled to a patterned metal layer on a bottom surface of die **56,** and the bottom patterned metal layer is physically, electrically, and thermally coupled to the exposed top surface of a thermal dissipation structure **97.** The output terminal of driver-stage die **56** is electrically coupled to the input terminal of final-stage die **58** through a wirebond array (not numbered) or another type of electrical connection. Final-stage die **58** also includes a plurality of integrated circuits. In an embodiment, the integrated circuitry of die **58** includes a series-coupled arrangement of an input terminal (not numbered), a GaN power transistor **96,** and an output terminal **120.** More specifically, the gate of transistor **96** is electrically coupled to the input terminal of die **58,** and the drain of transistor **96** is electrically coupled to output terminal **120** of die **58.** The source of transistor **96** is electrically coupled to a patterned metal layer on a bottom surface of die **58,** and the bottom patterned metal layer is physically, electrically, and thermally coupled to the exposed top surface of a thermal dissipation structure.

To ensure proper Doherty operation, the carrier amplifier may be biased to operate in a class AB mode, and the peaking amplifier may be biased to operate in a class C mode. To accomplish this biasing, a plurality of gate and drain bias voltages may be provided by external bias voltage sources. In embodiments, the bias voltages are provided through the bias terminals and electrically-routed lid **22.** Specifically, gate bias voltages for driver-stage transistors **90, 94** may be provided through driver gate bias terminals, drain bias voltages for driver-stage transistors **90, 94** may be provided through driver drain bias terminals, and gate bias voltages for final-stage transistors **92, 96** may be provided through gate bias terminals. Each of the terminals has a proximal end coupled to conductive structures (e.g., pads and traces) of patterned metal layer **68,** and the conductive structures are electrically coupled (e.g., through wirebonds, as shown) to bias pads on the driver- and final-stage dies. In the illustrated embodiment, the gate and drain bias pads for both driver- and final-stage transistors **90, 92, 94, 96** are located on driver-stage dies **52, 56,** and the gate bias voltage for final-stage dies **54, 58** "hops" from driver-stage dies **52, 56** to final-stage dies **54, 58** through wirebond connections, as shown. Returning again to the operation of PA package **10,** an amplified carrier signal is produced at output terminal **122** of final-stage die **54,** and an amplified peaking signal is produced at output terminal **120** of final-stage die **58,** which also functions as combining node **104** for the amplifier. According to an embodiment, output terminal **122** of carrier final-stage die **54** is electrically coupled (e.g., through wirebonds (not numbered) or another type of electrical connection) to a first end of the phase shift and impedance inversion element **118,** and output terminal **120** of peaking final-stage die 58 is electrically coupled (e.g., through wirebonds or another interconnect feature) to a second end of the phase shift and impedance inversion element **118.**

In embodiments, phase shift and impedance inversion element **118** may be implemented with a quarter-wavelength or lambda/4 (λ/4) or shorter transmission line (e.g., a microstrip transmission line with an electrical length up to about 90°) formed from a portion of patterned metal layer **68.** As utilized herein, lambda denotes the wavelength of an RF signal at the fundamental frequency of operation of PA package **10;** e.g., a frequency in a range of about 600 megahertz (MHz) to about 10 gigahertz (GHz) or higher. The combination of the phase shift and impedance inversion element **118** and the wirebond (or other) connections to output terminals **122, 120** of dies **54, 58** may impart about a 90° relative phase shift to the amplified carrier signal as the signal travels from output terminal **122** to output terminal **120**/combining node **104.** When the various phase shifts imparted separately on the carrier and peaking RF signals through the carrier and peaking paths, respectively, are substantially equal, the amplified carrier and peaking RF signals combine substantially in phase at output terminal **120**/combining node **104.** Output terminal **120**/combining node **104** is electrically coupled (e.g., through wirebonds or another type of electrical connection) through an output-side impedance matching network **106** to the RF output terminal. As previously noted, various other SMDs may also be mounted to populated frontside surface **50** of package substrate **20** to complete the circuitry of PA package **10,** with an example of one such SMD **124** (e.g., a chip cap) shown in FIG. 1 as electrically coupled to output-side impedance matching network **106** along the length of its transmission line. Comparing FIG. 4 to FIGS. 1-3, then, topside I/O interface **18** may include an RF input terminal and an RF output terminal, while sidewall-embedded vias **38** include (i) a first sidewall-embedded via formed in a first peripheral lid sidewall (e.g., the leftmost sidewall **32** in the orientation shown in FIG. 1) and electrically contacting the RF input terminal, and (ii) a second sidewall-embedded via formed in a second peripheral lid sidewall (e.g., the rightmost sidewall 32 in the orientation of Fig. 1) and electrically contacting the RF output terminal. Further, the first peripheral lid sidewall may be located opposite the second peripheral lid sidewall as taken along an axis perpendicular to the package height direction.

Advancing to FIG. 6, one manner in which PA package **10** may be installed within a larger electronic system or assembly **126** is illustrated in accordance with an example embodiment of the present disclosure. In this generalized example, electronic assembly **126** includes an assembly-level substrate **128,** such as a motherboard, to which PA package **10** is mounted in an inverted orientation such that package topside surface **12** faces and is located vertically adjacent assembly-level substrate **128.** Topside I/O interface **18** of PA package **10** is electrically coupled to corresponding interconnect features (e.g., bond pads and traces) on the upper surface of assembly-level substrate **128** utilizing any suitable interconnection technique, such as solder connections (noting reflowed solder bodies **130** in FIG. 6). An assembly-level heatsink **134** may be mounted directly to bottomside surface **14** of PA package **10** and bonded to bottomside thermal interface **28** utilizing, for example, a thermally-conductive bond layer **136** in embodiments. Only a limited portion of heatsink **134** and assembly-level substate **128** are shown in FIG. 6, noting that various other components may be distributed across the non-illustrated portions of assembly-level substrate **128** to form the desired circuit structure.

Thermally-conductive bond layer **136** can be composed of any thermally-conductive bonding material, such as a sintered bond layer or another bonding material (whether electrically conductive or dielectric) having a relatively low thermal resistance. In other embodiments, assembly-level heatsink **134** may be thermally coupled to bottomside thermal interface **28** in a less direct manner. For example, in other instances, assembly-level heatsink **134** may be spatially separated from PA package **10** and a thermal conduit, such as a metallic body or an elongated heat pipe, may be thermally coupled between heatsink **134** and bottomside thermal interface **28.** Regardless of its particular location relative to PA package **10,** assembly-level heatsink **134** can be any thermally-conductive structure or device suitable for absorbing excess heat extracted from PA package **10** through the bottomside thermal interface. For example, in embodiments, assembly-level heatsink **134** may be a metal chassis, a fin structure (e.g., a pin-fin array), or another thermally-conductive body external to PA package **10.** Assembly-level heatsink **134** may be convectively cooled by releasing heat to the ambient environment; and, in certain embodiments, a fan may direct airflow against assembly-level heatsink **134** to promote convective heat transfer to the impinging airflow. Generally, then, assembly-level heatsink **134** can assume different forms and configurations depending upon the characteristics of electronic assembly **126.** It is also possible for PA package **10** to be installed within a larger electronic system or assembly, while bottomside thermal interface **28** is left exposed (and thus not directly thermally coupled to a heatsink) if such an arrangement provides sufficient heat dissipation from PA package **10** in certain applications.

By virtue of its dual-sided, high thermal performance architecture, PA package **10** provides a primary thermal conduction path extending from the RF power die or dies housed within package **10,** through package substrate **20,** through backmetal layer **28,** through the thermally-conductive bond layer and bottomside surface **14,** and ultimately to assembly-level heatsink **134.** This primary thermal conduction path is non-tortuous and volumetrically robust, and may have a high metallic content or density to provide highly efficient heat flow from the packaged RF dies to assembly-level heatsink **134** in a direction opposite topside I/O interface **18** and assembly-level substrate **128.** The heat dissipation capabilities of PA package **10** are boosted as a result to limit peak temperatures within package **10** during PA package operation. This, in combination with the air cavity construction of PA package **10,** allow both the electrical and thermal performance characteristics of package **10** to be optimized relative to encapsulated packages having HTP architectures, air cavity packages lacking HTP architectures, and more conventional PA packages. Additionally, and as noted above, embodiments of PA package **10** are amenable to highly repeatable, reliable, and cost effective fabrication processes; while further mitigating issues encountered in connection with the fabrication of overmolded HTP PA packages containing interposer pieces. As a still further advantage, embodiments of HTP PA package **10** (and other PA packages produced in accordance with the present teachings) can be fabricated in parallel to lower manufacturing costs and durations. An example fabrication process for producing a relatively large number (e.g., several dozen) of HTP PA packages in parallel, with each PA package having an air cavity enclosed by an electrically-routed lid, will now be described in connection with FIGS. 7 and 8.

Initially referencing FIG. 7, an example PA package fabrication method **140** is set-forth, with method **140** performed on a larger (panel- or strip-level) scale to concurrently produce a relatively large number of PA packages in parallel to enhance process efficiencies and minimize manufacturing costs. In this particular example, PA package fabrication method **140** is carried-out utilizing an interconnected array of electrically-routed lids (e.g., a presingulated lid array **162,** described below), which mates to or is sealingly bonded to an interconnected array of package substrates (e.g., package substrate array **148,** described below) to concurrently enclose multiple air cavities contained in the PA packages undergoing fabrication. In keeping with the foregoing description, package fabrication method **140** will be described as producing a plurality of PA packages similar or identical to PA package **10** discussed above in connection with FIGS. 1-6, with the previously-introduced reference numerals carried forward as appropriate. It is emphasized, however, that package fabrication method **140** can be utilized in the manufacture of other HTP PA packages containing air cavities and electrically-routed lids. As noted above, variations of method **140** are equally applicable to fabrication of other microelectronic package types including, but not limited to, BGA and micro leadframe packages.

In the depicted embodiment, package fabrication method **140** is divided into three process stages or blocks **142, 144, 146.** To initiate method **140** (STAGE **142**), an interconnected package substrate array is obtained, whether by independent fabrication, by purchase from a supplier, or in another manner. Here, the presingulated package substrate array obtained during STAGE **142** ("obtain interconnected substrate array - e.g. substrate strip") assumes the form of an elongated substrate strip **148** containing a relatively large number of interconnected LGA substrates arranged in two grid layouts **150.** In other embodiments, the package substrate array may have various other formfactors. Next, during stage **144** ("perform array-level - e.g. strip level - process steps") of method **140,** die attach is performed (step **152**) to bond one or more RF power dies, and possibly other surface mount components (e.g., SMD capacitors, resistors, inductors, or the like), to the appropriate locations on the package substrates. A pick-and-place tool **154** may be employed for this purpose. Additionally, in keeping with the foregoing description, the presingulated package substrate array (elongated substrate strip **148**) may include embedded thermal dissipation structures (analogous to structures **97** shown in FIG. 5) such that the RF power dies to the thermal dissipation structures utilizing a thermally-conductive bonding material to form primary heat dissipation paths extending from the RF power dies, through the thermal dissipation structures, and to bottomside surfaces of the plurality of singulated PA packages following singulation (described below in connection with STAGE **146** of method **140**)**.** Wire bonding may be performed at step **156.**

Next, at STEP **160** ("attach interconnected lid array"), a presingulated lid array **162** is bonded to presingulated package substrate array **148** to enclose the RF power dies in sealed air cavities and produce a plurality of presingulated PA packages. Presingulated lid array **162** is positioned over presingulated package substrate array **148** to precisely align saw lanes of the lid array **162** (e.g., saw lanes **164,** described below) with matching saw lanes of presingulated package substrate array **148,** with fiducials potentially provided on presingulated lid array **162** to assist in the alignment process. Prior to positioning of presingulated lid array **162** over and onto package substrate array **148,** a dielectric bond material is applied to lower surfaces of the presingulated lid array and/or onto the populated surfaces of the presingulated package substrate array; e.g., an epoxy paste may be screen printed, applied by fine needle dispense, or otherwise applied to the appropriate surfaces, or a preformed epoxy film may be positioned against the appropriate surfaces and captured between arrays **148, 162** prior to curing. So too may the electrically-conductive bond material (forming electrically-conductive bond layer portions **57,** FIG. 5) be dispensed, cured, or otherwise formed at this juncture or at a prior juncture in the manufacturing process. After positioning of presingulated lid array **162** onto presingulated package substrate array **148,** the dielectric bond material is cured (e.g., by thermal processing) to yield the above-described dielectric bond layer **55** (FIG. 5) included in bond layer system **24.** Such a process thus attaches presingulated lid array **162** to presingulated package substrate array **148,** while concurrently enclosing the various air cavities contained in the presingulated PA packages.

Lastly, at STAGE **146** ("singulate & perform additional process steps as needed") of method **140,** the presingulated HTP PA packages are singulated to yield a plurality of singulated PA packages. A few instances of such PA packages are shown in the lower portion of FIG. 7, with each instance of the illustrated PA package corresponding to example PA package **10** discussed above in connection with FIGS. 1-6 in the depicted embodiment. Singulation may be carried-out utilizing a dicing sawing, although any other suitable singulation technique (e.g., scribing and punching) may be employed in other implementations. An example of a portion of presingulated lid array **162,** which is amenable to singulation via sawing, is shown in FIG. 8. As can be seen in this drawing figure, presingulated lid array **162** includes an intersecting grid of saw lanes **164,** as well as fiducials **166** to assist with the alignment and sawing processes. Saw lanes **164** vertically align with a similar grid or lattice of saw lanes provided on presingulated package substrate array **148** when arrays **148, 164** are properly aligned or stacked during the fabrication process. After directing a dicing saw through presingulated lid array **162** along saw lanes **164,** including the underlying regions of presingulated lid array **162,** the HTP PA packages are separated into discrete units, with each of these units including at least one RF power die located in an air cavity and electrically coupled to the topside I/O interface through sidewall-embedded vias, as previously described. Additional steps, such as physical and electrical testing, may then be performed to complete the manufacturing process, as appropriate.

### CONCLUSION

There has thus been provided HTP PA packages containing air cavities enclosed by specialized, electrically-routed lids, as well as methods for fabricating such PA packages in bulk. Due, at least in substantial part, to the unique, dual-sided, high thermal performance architecture and air cavity construction of the presently-disclosed PA packages, the PA packages are capable of achieving both optimal thermal and electrical performance characteristics, while remaining structurally robust or durable. Further, relative to comparable overmolded or plastic PA packages containing encapsulated components and interposer pieces, the presently-disclosed PA packages are less susceptible to coplanarity issues along the package mount plane and avoid or mitigate various challenges associated with interposer piece attachment and overmolding. As further discussed above, embodiments of the PA package are amenable to fabrication at scale (that is, in larger numbers) for increased process efficiencies and reduced manufacturing costs. Other benefits are also achieved by embodiments of the PA packages described herein, and the associated manufacturing techniques, as will be appreciated by one of ordinary skill in the relevant industry given the benefit of the present disclosure.

In embodiments, the presently-disclosed PA package includes a package body having a package topside surface and a package bottomside surface, which is located opposite the package topside surface in a package height direction. The package body is defined, at least in part, by a package substrate and an electrically-routed lid bonded to a populated side of the package substrate to sealingly enclose an air cavity. The electrically-routed lid includes, in turn, an upper lid wall at least partially defining the package topside surface, peripheral lid sidewalls joined to the upper lid wall and bounding a periphery of the air cavity, and sidewall-embedded vias contained in the peripheral lid sidewalls and each extending essentially in the package height direction. RF circuitry is attached to the populated side of the package substrate and located within the air cavity, while a topside I/O interface is supported by or otherwise provided on the upper lid wall and electrically interconnected with the RF circuitry through the sidewall-embedded vias of the electrically-routed lid. Further, in at least some instances, the peripheral lid sidewalls may include a first peripheral lid sidewall and a second peripheral lid sidewall, while the topside I/O interface includes an RF input terminal and an RF output terminal. In such instances, the sidewall-embedded vias may further include: (i) a first sidewall-embedded via electrically coupled to the RF input terminal and extending within the first peripheral lid sidewall from the RF input terminal toward the package substrate; and (ii) a second sidewall-embedded via electrically coupled to the RF output terminal and extending within the second peripheral lid sidewall from the RF output terminal toward the package substrate. The first peripheral lid sidewall may be located opposite the second peripheral lid sidewall as taken along an axis perpendicular to the package height direction, while an RF power die included in the RF circuitry may be located between the first peripheral lid sidewall and the second peripheral lid sidewall as further taken along the axis.

Embodiments of a method for fabricating a plurality of PA packages in parallel or as a batch have been further disclosed. In embodiments, the method includes the steps or processes of attaching RF power dies (and possibly other microelectronic components) to a presingulated package substrate array, electrically interconnecting the RF power dies to routing features of the interconnected package substrates (e.g., using wirebonding or another interconnection technique), and obtaining (e.g., independently fabricating or purchasing from a supplier) a presingulated lid array comprised of a plurality of electrically-routed lids. Each electrically-routed lid in the presingulated lid array includes: (i) an upper lid wall at least partially defining the package topside surface; (ii) peripheral lid sidewalls joined to the upper lid wall (e.g., to form an open box-like structure); (iii) sidewall-embedded vias extending in the peripheral lid sidewalls, and (iv) a topside I/O interface or array formed on the upper lid wall and electrically coupled to the sidewall-embedded vias. Embodiments of the fabrication method further includes bonding the presingulated lid array to the presingulated package substrate array to produce presingulated or physically-interconnected PA packages. The presingulated PA packages are then singulated (e.g., utilizing a dicing saw directed along saw lanes of the presingulated lid array) to yield a plurality of singulated PA packages. Each of the PA packages includes at least one RF power die located in an air cavity and electrically coupled to the topside I/O array through the sidewall-embedded vias.

Continuing the example from the foregoing paragraph, in certain implementations, the step or process of bonding may entail forming a bond layer system attaching the presingulated lid array to the presingulated package substrate array and electrically coupling bond pads on the presingulated package substrate array to substrate-facing lid contacts of the electrically-routed lid, which are electrically coupled to the sidewall-embedded vias (e.g., the substrate-facing lid contacts may electrically contact and may align with the sidewall-embedded vias as taken along axes extending in a package height direction). Additionally, in embodiments, the step or process of forming may further entail (i) applying a dielectric bond material (e.g., by dispensing a wet state material, such as an epoxy paste, or by positioning a bond layer film) on lower surfaces of the presingulated lid array or on populated surfaces of the presingulated package substrate array; (ii) positioning the presingulated lid array over the presingulated package substrate array such that the dielectric bond material contacts the presingulated lid array and the presingulated package substrate array; and (iii) curing the dielectric bond material to form a dielectric bond layer bonding the presingulated lid array to the presingulated package substrate array, while sealingly enclosing an air cavity within each of the singulated power amplifier packages. Electrically-conductive bond layer portions (e.g., composed of a dielectric epoxy) may also be formed in the dielectric bond layer (e.g., composed of an electrically-conductive epoxy), while the substrate-facing lid contacts are electrically coupled to lid-facing contacts on the presingulated package substrate array through the electrically-conductive bond layer portions.

While at least one example embodiment has been presented in the foregoing Detailed Description, it should be appreciated that a vast number of variations exist. It should also be appreciated that the example embodiment or example embodiments are only examples. Rather, the foregoing Detailed Description will provide those skilled in the art with a convenient road map for implementing an example embodiment of the invention, it being understood that various changes may be made in the function and arrangement of elements described in an example embodiment. Numerical identifiers, such as "first," "second," "third," and the like have been used above in accordance with the order in which certain elements were introduced during the course of the foregoing Detailed Description. Such numerical identifiers may also be used in the subsequent Claims to indicate order of introduction in the Claims. Accordingly, such numerical identifiers may vary between the Detailed Description and the subsequent Claims to reflect differences in the order of introduction of elements.

## Claims

1. A power amplifier package (10), comprising:
a package body (11,21) having a package topside surface (12) and a package bottomside surface (14) opposite the package topside surface in a package height direction, the package body comprising:
an air cavity (26);
a package substrate (20) having a populated side bounding a portion of the air cavity; and
an electrically-routed lid (22) bonded to the package substrate to sealingly enclose the air cavity, the electrically-routed lid comprising:
an upper lid wall (30) defining at least a portion of the package topside surface;
peripheral lid sidewalls (32) joined to the upper lid wall and bounding a periphery of the air cavity; and
sidewall-embedded vias (38) contained in the peripheral lid sidewalls and each extending essentially in the package height direction;
radio frequency (RF) circuitry attached to the populated side of the package substrate and located within the air cavity; and
a topside input/output (I/O) interface (18) on the packaged topside surface (12) and electrically interconnected with the RF circuitry through the sidewall-embedded vias (38) of the electrically-routed lid.

2. The power amplifier package (10) of claim 1, wherein the electrically-routed lid (22) further comprises substrate-facing lid contacts distributed along a lower edge of the peripheral lid sidewalls (32) and electrically coupled to the sidewall-embedded vias (38); and
wherein the package body (11, 21) further comprises lid-facing contacts provided on the populated side of the package substrate (20) and electrically interconnected with the substrate-facing lid contacts.

3. The power amplifier package (10) of claim 2, wherein the package body (11,21) further comprises a bond layer system (24) attaching the lower edge of the peripheral lid sidewalls (32) to the populated side of the package substrate, the substrate-facing lid contacts electrically coupled to the lid-facing contacts through the bond layer system (24) .

4. The power amplifier package (10) of claim 3, wherein the bond layer system (24) comprises:
a dielectric bond layer (55) extending around the lower edge of the peripheral lid sidewalls to form a 360 degree seal at an interface between the electrically-routed lid and the package substrate; and
electrically-conductive bond layer portions (57) distributed in the dielectric bond layer (55), the substrate-facing lid contacts electrically coupled to the lid-facing contacts through the electrically-conductive bond layer portions (57).

5. The power amplifier package (10) of claim 4, wherein the dielectric bond layer (55) is composed of a dielectric epoxy; and
wherein the electrically-conductive bond layer portions (57) are composed of an electrically-conductive epoxy.

6. The power amplifier package (10) of claim 4, wherein the dielectric bond layer (55) is composed of a B stage epoxy.

7. The power amplifier package (10) of any of claims 2 to 6, wherein the lid-facing contacts align with corresponding ones of the substrate-facing lid contacts as taken along axes extending in the package height direction.

8. The power amplifier package (10) of any preceding claim, wherein the topside I/O interface (18) comprises electrically-conductive pads formed on a surface of the upper lid wall (30) facing away from the package substrate (20) and in contact with the sidewall-embedded vias (38).

9. The power amplifier package (10) of any preceding claim, wherein the upper lid wall (30) and the peripheral lid sidewalls (32) are composed of a molded dielectric material; and
wherein the sidewall-embedded vias (38) are at least partly composed of a metallic material.

10. The power amplifier package (10) of claim 9, wherein the sidewall-embedded vias (38) comprise plated through holes formed in the peripheral lid sidewalls (32).

11. The power amplifier package (10) of claim 10, wherein the plated through holes each comprise:
a tubular plated layer electrically coupling a terminal included in the topside I/O interface (18) to a lid-facing contact included in the lid-facing contacts; and
a backfill material surrounded by the tubular plated layer; and
a metallic cap covering the plated through hole, electrically coupled to the tubular plated layer, and forming a contact in the topside I/O interface (18) of the power amplifier package (10).

12. The power amplifier package (10) of any preceding claim, wherein the RF circuitry comprises an RF power die; and
wherein the package body (11,21) further comprises:
a thermal dissipation structure embedded in the package substrate (20) and to which the RF power die is attached; and
a primary heat dissipation path extending from the RF power die, through the thermal dissipation structure, and to the package bottomside surface (14) in a direction opposite the electrically-routed lid.

13. The power amplifier package (10) of any preceding claim, wherein the peripheral lid sidewalls (32) comprise a first peripheral lid sidewall and a second peripheral lid sidewall;
wherein the topside I/O interface (18) comprises an RF input terminal (76) and an RF output terminal (78); and
wherein the sidewall-embedded vias (38) comprise:
a first sidewall-embedded via electrically coupled to the RF input terminal (76) and extending within the first peripheral lid sidewall from the RF input terminal toward the package substrate; and
a second sidewall-embedded via electrically coupled to the RF output terminal (78) and extending within the second peripheral lid sidewall from the RF output terminal toward the package substrate.

14. The power amplifier package (10) of claim 13, wherein the first peripheral lid sidewall is located opposite the second peripheral lid sidewall as taken along an axis perpendicular to the package height direction; and
wherein the RF circuitry comprises an RF power die located between the first peripheral lid sidewall and the second peripheral lid sidewall as further taken along the axis.

15. A method (140) for fabricating power amplifier packages, comprising:
attaching (152) radio frequency, RF, power dies to a presingulated package substrate array;
electrically interconnecting the RF power dies to routing features of the presingulated package substrate array;
obtaining a presingulated lid array comprised of a plurality of electrically-routed lids, each lid comprising:
an upper lid wall;
peripheral lid sidewalls joined to the upper lid wall;
sidewall-embedded vias extending in the peripheral lid sidewalls; and
a topside input/output, I/O, array formed on the upper lid wall and electrically coupled to the sidewall-embedded vias;
bonding (160) the presingulated lid array to the presingulated package substrate array to enclose the RF power dies in sealed air cavities and produce a plurality of presingulated power amplifier packages; and
singulating (146) the plurality of presingulated power amplifier packages to yield singulated power amplifier packages according to claim 1, the singulated power amplifier packages each including at least one RF power die located in an air cavity and electrically coupled to the topside I/O interface through the sidewall-embedded vias.

## Patentansprüche

1. Leistungsverstärkergehäuse (10), umfassend:
einen Gehäusekörper (11, 21) mit einer Gehäuseoberseitenoberfläche (12) und einer Gehäuseunterseitenoberfläche (14) gegenüber der Gehäuseoberseitenoberfläche in einer Gehäusehöhenrichtung, wobei der Gehäusekörper umfasst:
einen Lufthohlraum (26);
ein Gehäusesubstrat (20) mit einer bestückten Seite, die einen Anteil des Lufthohlraums begrenzt; und
einen elektrisch geführten Deckel (22), der an das Gehäusesubstrat gebondet ist, um den Lufthohlraum abdichtend zu umschließen, wobei der elektrisch geführte Deckel umfasst:
eine obere Deckelwand (30), die zumindest einen Anteil der Gehäuseoberseitenoberfläche definiert;
periphere Deckelseitenwände (32), die mit der oberen Deckelwand verbunden sind und einen Umfang des Lufthohlraums begrenzen; und
seitenwandeingebettete Vias (38), die in den peripheren Deckelseitenwänden enthalten sind und sich jeweils im Wesentlichen in der Gehäusehöhenrichtung erstrecken;
eine Hochfrequenz(HF)-Schaltungsanordnung, die an der bestückten Seite des Gehäusesubstrats befestigt ist und sich innerhalb des Lufthohlraums befindet; und
eine Oberseiten-Eingabe/Ausgabe(E/A)-Schnittstelle (18) auf der Gehäuseoberseitenoberfläche (12), und die durch die seitenwandeingebetteten Vias (38) des elektrisch geführten Deckels elektrisch mit der HF-Schaltungsanordnung verschaltet ist.

2. Leistungsverstärkergehäuse (10) nach Anspruch 1, wobei der elektrisch geführte Deckel (22) ferner substratzugewandte Deckelkontakte umfasst, die entlang eines unteren Rands der peripheren Deckelseitenwände (32) verteilt und elektrisch mit den seitenwandeingebetteten Vias (38) gekoppelt sind; und
wobei der Gehäusekörper (11, 21) ferner deckelzugewandte Kontakte umfasst, die auf der bestückten Seite des Gehäusesubstrats (20) bereitgestellt sind und elektrisch mit den substratzugewandten Deckelkontakten verschaltet sind.

3. Leistungsverstärkergehäuse (10) nach Anspruch 2, wobei der Gehäusekörper (11, 21) ferner ein Bondschichtsystem (24) umfasst, das den unteren Rand der peripheren Deckelseitenwände (32) an der bestückten Seite des Gehäusesubstrats befestigt, wobei die substratzugewandten Deckelkontakte durch das Bondschichtsystem (24) elektrisch mit den deckelzugewandten Kontakten gekoppelt sind.

4. Leistungsverstärkergehäuse (10) nach Anspruch 3, wobei das Bondschichtsystem (24) umfasst:
eine dielektrische Bondschicht (55), die sich um den unteren Rand der peripheren Deckelseitenwände herum erstreckt, um eine 360-Grad-Dichtung an einer Grenzfläche zwischen dem elektrisch geführten Deckel und dem Gehäusesubstrat zu bilden; und
elektrisch leitfähige Bondschichtanteile (57), die in der dielektrischen Bondschicht (55) verteilt sind, wobei die substratzugewandten Deckelkontakte durch die elektrisch leitfähigen Bondschichtanteile (57) elektrisch mit den deckelzugewandten Kontakten gekoppelt sind.

5. Leistungsverstärkergehäuse (10) nach Anspruch 4, wobei die dielektrische Bondschicht (55) aus einem dielektrischen Epoxid zusammengesetzt ist; und
wobei die elektrisch leitfähigen Bondschichtanteile (57) aus einem elektrisch leitfähigen Epoxid zusammengesetzt sind

6. Leistungsverstärkergehäuse (10) nach Anspruch 4, wobei die dielektrische Bondschicht (55) aus einem B-Stufen-Epoxid zusammengesetzt ist.

7. Leistungsverstärkergehäuse (10) nach einem der Ansprüche 2 bis 6, wobei die deckelzugewandten Kontakte mit entsprechenden der substratzugewandten Deckelkontakte ausgerichtet sind, genommen entlang Achsen, die sich in der Gehäusehöhenrichtung erstrecken.

8. Leistungsverstärkergehäuse (10) nach einem der vorhergehenden Ansprüche, wobei die Oberseiten-E/A-Schnittstelle (18) elektrisch leitfähige Pads umfasst, die auf einer Oberfläche der oberen Deckelwand (30) gebildet sind, die von dem Gehäusesubstrat (20) weg weist, und in Kontakt mit den seitenwandeingebetteten Vias (38) stehen.

9. Leistungsverstärkergehäuse (10) nach einem der vorhergehenden Ansprüche, wobei die obere Deckelwand (30) und die peripheren Deckelseitenwände (32) aus einem geformten dielektrischen Material zusammengesetzt sind; und
wobei die seitenwandeingebetteten Vias (38) zumindest teilweise aus einem metallischen Material zusammengesetzt sind.

10. Leistungsverstärkergehäuse (10) nach Anspruch 9, wobei die seitenwandeingebetteten Vias (38) plattierte Durchgangslöcher umfassen, die in den peripheren Deckelseitenwänden (32) gebildet sind.

11. Leistungsverstärkergehäuse (10) nach Anspruch 10, wobei die plattierten Durchgangslöcher jeweils umfassen:
eine röhrenförmige plattierte Schicht, die einen Anschluss, der in die Oberseiten-E/A-Schnittstelle (18) eingeschlossen ist, elektrisch mit einem deckelzugewandten Kontakt koppelt, der in die deckelzugewandten Kontakte eingeschlossen ist; und
ein Hinterfüllmaterial, das von der röhrenförmigen plattierten Schicht umgeben ist; und
eine metallische Kappe, die das plattierte Durchgangsloch bedeckt, elektrisch mit der röhrenförmigen plattierten Schicht gekoppelt ist und einen Kontakt in der Oberseiten-E/A-Schnittstelle (18) des Leistungsverstärkergehäuses (10) bildet.

12. Leistungsverstärkergehäuse (10) nach einem der vorhergehenden Ansprüche, wobei die HF-Schaltungsanordnung einen HF-Leistungschip umfasst; und wobei der Gehäusekörper (11, 21) ferner umfasst:
eine Wärmeableitstruktur, die in das Gehäusesubstrat (20) eingebettet ist und an der der HF-Leistungschip befestigt ist; und
einen primären Wärmeableitpfad, der sich von dem HF-Leistungschip durch die Wärmeableitstruktur und zu der Gehäuseunterseitenoberfläche (14) in einer Richtung entgegengesetzt zu dem elektrisch geführten Deckel erstreckt.

13. Leistungsverstärkergehäuse (10) nach einem der vorhergehenden Ansprüche, wobei die peripheren Deckelseitenwände (32) eine erste periphere Deckelseitenwand und eine zweite periphere Deckelseitenwand umfassen;
wobei die Oberseiten-E/A-Schnittstelle (18) einen HF-Eingangsanschluss (76) und einen HF-Ausgangsanschluss (78) umfasst; und
wobei die seitenwandeingebetteten Vias (38) umfassen:
eine erste seitenwandeingebettete Via, die elektrisch mit dem HF-Eingangsanschluss (76) gekoppelt ist und sich innerhalb der ersten peripheren Deckelseitenwand von dem HF-Eingangsanschluss zu dem Gehäusesubstrat erstreckt; und
eine zweite seitenwandeingebettete Via, die elektrisch mit dem HF-Ausgangsanschluss (78) gekoppelt ist und sich innerhalb der zweiten peripheren Deckelseitenwand von dem HF-Ausgangsanschluss zu dem Gehäusesubstrat erstreckt.

14. Leistungsverstärkergehäuse (10) nach Anspruch 13, wobei die erste periphere Deckelseitenwand sich gegenüber von der zweiten peripheren Deckelseitenwand befindet, genommen entlang einer Achse senkrecht zu der Gehäusehöhenrichtung; und
wobei die HF-Schaltungsanordnung einen HF-Leistungschip umfasst, der sich zwischen der ersten peripheren Deckelseitenwand und der zweiten peripheren Deckelseitenwand befindet, wie ferner entlang der Achse genommen wurde.

15. Verfahren (140) zum Fertigen von Leistungsverstärkergehäusen, umfassend:
Befestigen (152) von Hochfrequenz-, HF-, Leistungschips an einem vorvereinzelten Gehäusesubstratarray;
elektrisches Verschalten der HF-Leistungschips mit Führungsmerkmalen des vorvereinzelten Gehäusesubstratarrays;
Erhalten eines vorvereinzelten Deckelarrays, das eine Vielzahl von elektrisch geführten Deckeln umfasst, wobei jeder Deckel umfasst:
eine obere Deckelwand;
periphere Deckelseitenwände, die mit der oberen Deckelwand verbunden sind;
seitenwandeingebettete Vias, die sich in den peripheren Deckelseitenwänden erstrecken; und
ein Oberseiten-Eingabe/Ausgabe-, E/A-, Array, das an der oberen Deckelwand gebildet ist und elektrisch mit den seitenwandeingebetteten Vias gekoppelt ist;
Bonden (160) des vorvereinzelten Deckelarrays an das vorvereinzelte Gehäusesubstratarray, um die HF-Leistungschips in abgedichteten Lufthohlräumen zu umschließen und eine Vielzahl von vorvereinzelten Leistungsverstärkergehäuse zu produzieren; und
Vereinzeln (146) der Vielzahl von vorvereinzelten Leistungsverstärkergehäusen, um vereinzelte Leistungsverstärkergehäuse nach Anspruch 1 zu ergeben, wobei die vereinzelten Leistungsverstärkergehäuse jeweils zumindest einen HF-Leistungschip einschließen, der sich in einem Lufthohlraum befindet und elektrisch mit der Oberseiten-E/A-Schnittstelle durch seitenwandeingebetteten Vias gekoppelt ist.

## Revendications

1. Boîtier d'amplificateur de puissance (10), comprenant :
un corps de boîtier (11, 21) comportant une surface côté supérieur de boîtier (12) et une surface côté inférieur de boîtier (14) à l'opposé de la surface côté supérieur de boîtier dans la direction d'une hauteur du boîtier, le corps de boîtier comprenant :
une cavité d'air (26) ;
un substrat de boîtier (20) comportant un côté garni délimitant une partie de la cavité d'air ; et
un couvercle à routage électrique (22) assemblé au substrat de boîtier pour enfermer hermétiquement la cavité d'air, le couvercle à routage électrique comprenant :
une paroi supérieure de couvercle (30) définissant au moins une partie de la surface côté supérieur de boîtier ;
des parois latérales périphériques de couvercle (32) reliées à la paroi supérieure de couvercle et délimitant une périphérie de la cavité d'air ; et
des trous d'interconnexion intégrés aux parois latérales (38) contenus dans les parois latérales périphériques de couvercle et s'étendant chacun essentiellement dans la direction de la hauteur du boîtier ;
des circuits radiofréquence (RF) fixés au côté garni du substrat de boîtier et situés à l'intérieur de la cavité d'air ; et
une interface d'entrée/sortie (E/S) côté supérieur (18) sur la surface côté supérieur de boîtier (12) et interconnectée électriquement aux circuits RF par le biais des trous d'interconnexion intégrés aux parois latérales (38) du couvercle à routage électrique.

2. Boîtier d'amplificateur de puissance (10) de la revendication 1, dans lequel le couvercle à routage électrique (22) comprend en outre des contacts de couvercle faisant face au substrat répartis le long d'un bord inférieur des parois latérales périphériques de couvercle (32) et couplés électriquement aux trous d'interconnexion intégrés aux parois latérales (38) ; et dans lequel le corps de boîtier (11, 21) comprend en outre des contacts faisant face au couvercle disposés sur le côté garni du substrat de boîtier (20) et interconnectés électriquement aux contacts de couvercle faisant face au substrat.

3. Boîtier d'amplificateur de puissance (10) de la revendication 2, dans lequel le corps de boîtier (11, 21) comprend en outre un système de couches d'assemblage (24) fixant le bord inférieur des parois latérales périphériques de couvercle (32) au côté garni du substrat de boîtier, les contacts de couvercle faisant face au substrat étant couplés électriquement aux contacts faisant face au couvercle par le biais du système de couches d'assemblage (24).

4. Boîtier d'amplificateur de puissance (10) de la revendication 3, dans lequel le système de couches d'assemblage (24) comprend :
une couche d'assemblage diélectrique (55) s'étendant autour du bord inférieur des parois latérales périphériques de couvercle pour former un joint d'étanchéité sur 360 degrés au niveau d'une interface entre le couvercle à routage électrique et le substrat de boîtier ; et
des parties de couche d'assemblage électriquement conductrices (57) réparties dans la couche d'assemblage diélectrique (55), les contacts de couvercle faisant face au substrat étant couplés électriquement aux contacts faisant face au couvercle par le biais des parties de couche d'assemblage électriquement conductrices (57).

5. Boîtier d'amplificateur de puissance (10) de la revendication 4, dans lequel la couche d'assemblage diélectrique (55) est composée d'une résine époxy diélectrique ; et
les parties de couche de liaison électriquement conductrices (57) sont composées d'une résine époxy électriquement conductrice.

6. Boîtier d'amplificateur de puissance (10) de la revendication 4, dans lequel la couche d'assemblage diélectrique (55) est composée d'une résine époxy à l'état B.

7. Boîtier d'amplificateur de puissance (10) de l'une quelconque des revendications 2 à 6, dans lequel les contacts faisant face au couvercle s'alignent avec des contacts correspondants parmi les contacts de couvercle faisant face au substrat, pris le long d'axes s'étendant dans la direction de la hauteur du boîtier.

8. Boîtier d'amplificateur de puissance (10) d'une quelconque revendication précédente, dans lequel l'interface E/S côté supérieur (18) comprend des plots électriquement conducteurs formés sur une surface de la paroi supérieure de couvercle (30) tournant le dos au substrat de boîtier (20) et en contact avec les trous d'interconnexion intégrés aux parois latérales (38).

9. Boîtier d'amplificateur de puissance (10) d'une quelconque revendication précédente, dans lequel la paroi supérieure de couvercle (30) et les parois latérales périphériques de couvercle (32) sont composées d'un matériau diélectrique moulé ; et
dans lequel les trous d'interconnexion intégrés aux parois latérales (38) sont au moins partiellement composés d'un matériau métallique.

10. Boîtier d'amplificateur de puissance (10) de la revendication 9, dans lequel les trous d'interconnexion intégrés aux parois latérales (38) comprennent des trous traversants métallisés formés dans les parois latérales périphériques de couvercle (32).

11. Boîtier d'amplificateur de puissance (10) de la revendication 10, dans lequel chacun des trous traversants métallisés comprend :
une couche métallisée tubulaire couplant électriquement une borne incluse dans l'interface E/S côté supérieur (18) à un contact faisant face au couvercle inclus dans les contacts faisant face au couvercle ; et
un matériau de remplissage entouré par la couche métallisée tubulaire ; et
un capuchon métallique recouvrant le trou traversant métallisé, couplé électriquement à la couche métallisée tubulaire, et formant un contact dans l'interface E/S côté supérieur (18) du boîtier d'amplificateur de puissance (10).

12. Boîtier d'amplificateur de puissance (10) d'une quelconque revendication précédente, dans lequel les circuits RF comprennent une puce de puissance RF ; et
dans lequel le corps de boîtier (11, 21) comprend en outre :
une structure de dissipation thermique intégrée au substrat de boîtier (20) et à laquelle la puce de puissance RF est fixée ; et
un chemin de dissipation thermique principal s'étendant depuis la puce de puissance RF, à travers la structure de dissipation thermique, et jusqu'à la surface côté inférieur de boîtier (14) dans une direction opposée au couvercle à routage électrique.

13. Boîtier d'amplificateur de puissance (10) d'une quelconque revendication précédente, dans lequel les parois latérales périphériques de couvercle (32) comprennent une première paroi latérale périphérique de couvercle et une deuxième paroi latérale périphérique de couvercle ;
dans lequel l'interface E/S côté supérieur (18) comprend une borne d'entrée RF (76) et une borne de sortie RF (78) ; et
dans lequel les trous d'interconnexion intégrés aux parois latérales (38) comprennent :
un premier trou d'interconnexion intégré aux parois latérales, couplé électriquement à la borne d'entrée RF (76) et s'étendant à l'intérieur de la première paroi latérale périphérique de couvercle depuis la borne d'entrée RF vers le substrat de boîtier ; et
un deuxième trou d'interconnexion intégré aux parois latérales, couplé électriquement à la borne de sortie RF (78) et s'étendant à l'intérieur de la deuxième paroi latérale périphérique de couvercle depuis la borne de sortie RF vers le substrat de boîtier.

14. Boîtier d'amplificateur de puissance (10) de la revendication 13, dans lequel la première paroi latérale périphérique de couvercle est située à l'opposé de la deuxième paroi latérale périphérique de couvercle, prise le long d'un axe perpendiculaire à la direction de la hauteur du boîtier ; et
dans lequel les circuits RF comprennent une puce de puissance RF située entre la première paroi latérale périphérique de couvercle et la deuxième paroi latérale périphérique de couvercle, également prise le long de l'axe.

15. Procédé (140) destiné à fabriquer des boîtiers d'amplificateur de puissance, comprenant :
la fixation (152) de puces de puissance radiofréquence, RF, à une matrice de substrats de boîtier pré-individualisés ;
l'interconnexion électrique des puces de puissance RF à des éléments de routage de la matrice de substrats de boîtier pré-individualisé ;
l'obtention d'une matrice de couvercles pré-individualisés composée d'une pluralité de couvercles à routage électrique, chaque couvercle comprenant :
une paroi supérieure de couvercle ;
des parois latérales périphériques de couvercle reliées à la paroi supérieure de couvercle ;
des trous d'interconnexion intégrés aux parois latérales s'étendant dans les parois latérales périphériques de couvercle ; et
une matrice d'entrées/sorties, E/S, côté supérieur formée sur la paroi supérieure de couvercle et couplée électriquement aux trous d'interconnexion intégrés aux parois latérales ;
l'assemblage (160) de la matrice de couvercles pré-individualisés à la matrice de substrats de boîtier pré-individualisés pour enfermer les puces de puissance RF dans des cavités d'air scellées et produire une pluralité de boîtiers d'amplificateur de puissance pré-individualisés ; et
l'individualisation (146) de la pluralité de boîtiers d'amplificateur de puissance pré-individualisés pour produire des boîtiers d'amplificateur de puissance individualisés selon la revendication 1, chacun des boîtiers d'amplificateur de puissance individualisés comportant au moins une puce de puissance RF située dans une cavité d'air et couplée électriquement à l'interface E/S côté supérieur par le biais des trous d'interconnexion intégrés aux parois latérales.
